# EUROPEAN PATENT APPLICATION

(11) **EP 2 887 661 A1**
(43) Date of publication of application: **24.06.2015**
(21) Application number: 14198117.5
(22) Date of filing: 16.12.2014
(51) Int. Cl.: H04N 13/04, G02F 1/1333, G02F 1/1345, G02F 1/1347, G02B 27/22

(54) **Apparatus for displaying a three-dimensional image**

(30) Priority: 19.12.2013 KR 20130159535
(71) Applicant: Samsung Electronics Co., Ltd, Gyeonggi-do 443-742 (KR)
(72) Inventor: Park, Jae Hyun, Seoul (KR); Min, Il Ki, Gyeonggi-do (KR)
(74) Representative: Walaski, Jan Filip

(57) **Abstract**

A three-dimensional (3D) image display device is provided. The 3D image display device comprises a first display panel, a second display panel spaced apart from the first display panel at a front side of the first display panel to display a three-dimensional (3D) image, and a spacing panel. A back surface of the spacing panel is coupled to the first display panel and a front surface thereof is coupled to the second display panel. As a result, a specific state in which a predetermined spacing between the first display panel and the second display panel is uniformly maintained through the spacing panel.

## Description

The present invention relates to an apparatus for displaying a three-dimensional (3D) image (also called a stereoscopic image), and more particularly, to a three-dimensional (3D) image display device which is configured to maintain a constant spacing between a first display panel and a second display panel.

In the related art, a three-dimensional (3D) image display device includes a display panel on which images are displayed.

The 3D image display device includes a first display panel to display a first image thereon and a second display panel to display a second image which has a viewing angle different from the viewing angle of the first image. The first display panel and the second display panel are arranged parallel to each other in a forward and backward direction. As a result, the 3D image display device enables a user to simultaneously view both the first image and the second image which have a difference in viewing angles therebetween, such that the user can view the 3D image without wearing glasses.

However, the spacing between the first display panel and the second display panel may not be consistent, thereby distorting the displayed 3D image. In other words, a transformation may occur between the first display panel and the second display panel, and image distortion may be caused by the transformation of the first and second display panels. Accordingly, a display apparatus is needed where the spacing between the first and second display panels is maintained in a consistent manner in order to prevent image distortion.

Therefore, it is an aspect of the exemplary embodiments to provide a display apparatus which has a structure comprising a first printed circuit board (PCB) for a first display panel and a second PCB for a second display panel, where the first display panel and the second display panel are spaced apart from each other in a forward direction and a backward direction.

According to an aspect of the exemplary embodiments there is provided a three-dimensional (3D) image display device which is configured to maintain a constant spacing between a first display panel and a second display panel.

Additional aspects of the exemplary embodiments will be set forth in part in the description which follows and, in part, will be obvious from the description, or may be learned by practice of the exemplary embodiments.

In accordance with an aspect of the exemplary embodiments, there is provided a three-dimensional (3D) image display device which includes: a display module; a backlight module disposed at a rear side of the display module so as to provide light to the display module; and a main frame configured to support the display module and the backlight module. The display module includes: a first display panel configured to display a two-dimensional (2D) image; a second display panel spaced apart from the first display panel at a front side of the first display panel and configured to display a three-dimensional (3D) image; a first printed circuit board (PCB) configured to control the first display panel; a second PCB configured to control the second display panel; a first flexible PCB which interconnects the first display panel and the first PCB; and a second flexible PCB which interconnects the second display panel and the second PCB.

The display module may include a spacing panel, a back surface of which is coupled to the first display panel and a front surface of which is coupled to the second display panel.

The spacing panel may be formed of a transparent material. However, the spacing panel may be formed of a different type of material.

The outer wall of the spacing panel may protrude between or above the first display panel and the second display panel; and the main frame may support the spacing-panel circumference protruding between or above the first display panel and the second display panel.

The main frame may be formed in a rectangular ring shape, and may include a seating groove in which the outer wall of the spacing panel is seated.

The three-dimensional (3D) image display device may further include: a case which is coupled to the main frame, wherein the case includes a bezel portion to cover an outer wall of the second display panel and a lateral portion to cover a lateral surface of the main frame.

The main frame may include a catching protrusion which protrudes from an end part of the main frame such that the backlight module is caught in the catching protrusion. The backlight module may include an installation bracket mounted to an external part of the backlight module such that the backlight module is caught in the catching protrusion.

The backlight module may include: a light source; a diffusion plate arranged at a front side of the light source; a backlight frame to support the light source and the diffusion plate; a support bracket installed at the backlight frame to support an outer wall of the diffusion plate in a manner that a specific state in which the diffusion plate is mounted to the backlight frame is maintained; and a rear chassis to cover a rear side of the backlight frame.

The light source may include a plurality of light emitting diodes (LEDs) and a substrate on which the LEDs are located.

The first PCB and the second PCB may be disposed to be spaced parallel to each other in a direction perpendicular to the first display panel and the second display panel.

The first PCB coupled to one end of the first display panel and the second PCB coupled to one end of the second display panel may be spaced parallel to each other.

The first PCB may be arranged at a first end of the first display panel, and the second PCB may be arranged at a second end of the second display panel located opposite to the first end of the first display panel.

The first PCB may be arranged parallel to the first display panel at a rear side of the first display panel, and the second PCB may be arranged perpendicular to the second display panel.

The first PCB may be arranged parallel to the first display panel at a rear side of a first end of the first display panel. The second PCB may be arranged parallel to the second display panel at a rear side of a second end of the second display panel located opposite to the first end. The first PCB may be arranged at a rear side of the second PCB in response to a spacing distance between the first display panel and the second display panel.

The main frame may include a substrate accommodation groove concaved at an external surface of the main frame in a manner that the substrate accommodation groove accommodates at least the second PCB from among the first and second PCBs therein.

These and/or other aspects will become apparent and more readily appreciated from the following description of the exemplary embodiments, taken in conjunction with the accompanying drawings in which:
FIG. 1 is a perspective view illustrating a three-dimensional (3D) image display device according to an exemplary embodiment.
FIG. 2 is an exploded perspective view illustrating the 3D image display device according to an exemplary embodiment.
FIG. 3 is a cross-sectional view illustrating a 3D image display device according to a first exemplary embodiment.
FIG. 4 is a cross-sectional view illustrating a 3D image display device according to a second exemplary embodiment.
FIG. 5 is a cross-sectional view illustrating a 3D image display device according to a third exemplary embodiment.
FIG. 6 is a cross-sectional view illustrating a 3D image display device according to a fourth exemplary embodiment.

Reference will now be made in detail to the exemplary embodiments, examples of which are illustrated in the accompanying drawings, wherein like reference numerals refer to like elements throughout. A three-dimensional (3D) image display device according to the exemplary embodiments will hereinafter be described with reference to the attached drawings.

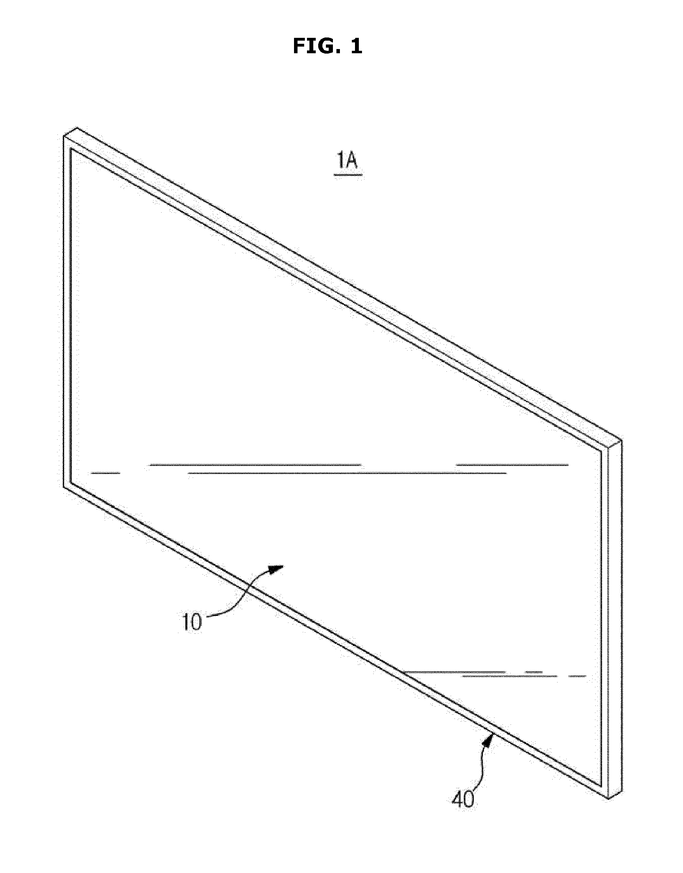

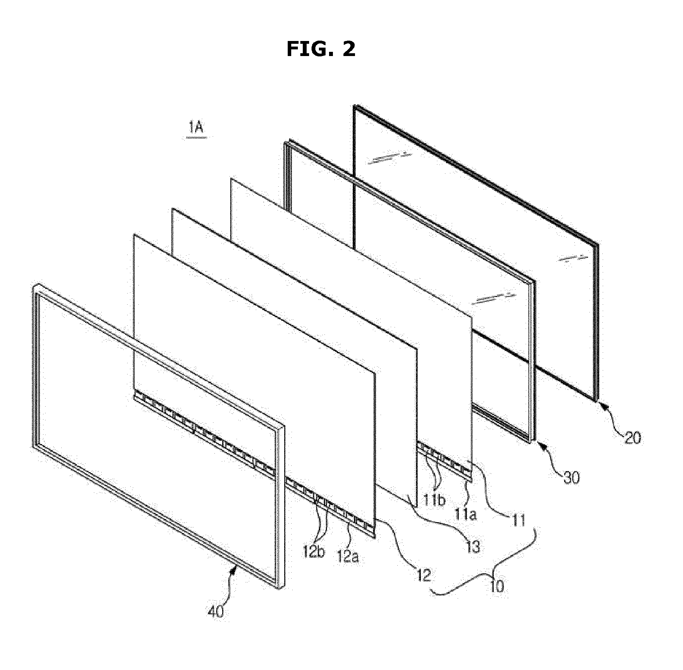

Referring to FIGS. 1 and 2, the 3D image display device 1A according to a first exemplary embodiment includes a display module 10 to display an image thereon, a backlight module 20 arranged at the rear of the display module 10 so as to provide light to the display module 10, a main frame 30 to support the display module 10 and the backlight module 20, and a case 40 installed at the main frame 30 so as to form the external structure of the 3D image display device 1A. The case 40 encompasses the display module 10, the main frame 30, and the backlight module 20.

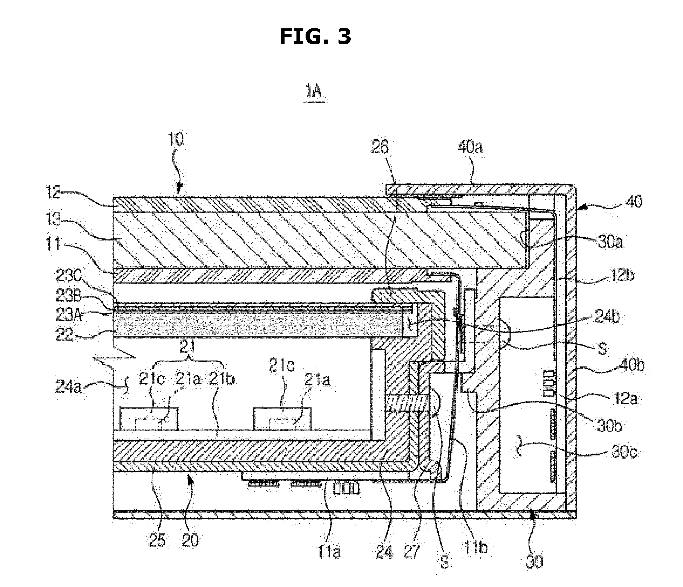

Referring to FIG. 3, the display module 10 includes a first display panel 11 to display a two-dimensional (2D) image thereon, a second display panel 12 spaced apart from the front of the first display panel 11 by a predetermined distance so as to display a 3D image in cooperation with the first display panel 11, and a spacing panel 13 disposed between the first display panel 11 and the second display panel 12 so as to maintain a predetermined spacing between the first display panel 11 and the second display panel 12.

The first display panel 11 displays a first image thereon. The second display panel 12 displays a second image having a viewing angle different from the viewing angle of the first image. The user, who simultaneously views the first image and the second image having a difference in viewing angle there-between, can recognize an image displayed on the 3D image display device 1A as a 3D image serving as a stereoscopic image.

In order to control the first display panel 11, a first printed circuit board (PCB) 11a (also referred to as a source PCB, or control PCB) is coupled to one side of the first display panel 11 through a first flexible PCB 11b. In order to control the second display panel 12, a second PCB 12a is coupled to one side of the second display panel 12 through a second flexible PCB 12b. In this exemplary embodiment, a chip is located on each of a first flexible PCB 11b and a second flexible PCB 12b, resulting in implementation of a COF (Chip On Flexible printed circuit).

Each of the first display panel 11 and the second display panel 12 may be comprised of a liquid crystal panel shaped as a rectangular plate having a predetermined size. However, the shape of the display panels is not limited thereto. The spacing panel 13 having a predetermined thickness may be configured in the form of a rectangular plate formed of a transparent material through which light is transmitted. However, the shape of the spacing panel is not limited thereto.

The first display panel 11 is attached to a back surface of the spacing panel 13, and the second panel 12 is attached to a front surface of the spacing panel 13. The first display panel 11 and the second display panel 12 are attached to the spacing panel 13 through various optical bonding materials, such that the loss of light can be prevented from occurring at a boundary among the spacing panel 13, the first display panel 11, and the second display panel 12.

As described above, if the first display panel 11 is attached to the back surface of the spacing panel 13, and the second display panel 12 is attached to the front surface of the spacing panel 13, a predetermined spacing between the first display panel 11 and the second display panel 12 can be correctly and persistently maintained through the spacing panel 13 irrespective of regions where the 3D image is displayed. Accordingly, a difference in viewing angle between the first image and the second image can be correctly maintained irrespective of viewing regions, such that the user can view a correct stereoscopic (3D) image.

The spacing panel 13 is formed to have a larger vertical width and a larger horizontal width as compared to the first display panel 11 and the second display panel 12, and when the first display panel 11 and the second display panel 12 are attached to the spacing panel 13, an end part of the outer wall of the spacing panel 13 is protruded between the first display panel 11 and the second display panel 12.

The backlight module 20 includes a light source 21 to emit light; a diffusion plate 22 arranged at the front of the light source 21 so as to diffuse light; a plurality of optical sheets (23A, 23B, 23C) arranged at the front surface of the diffusion plate 22; a backlight frame 24 to support the light source 21 and the diffusion plate 22; a rear chassis 25 arranged at the rear side of the backlight frame 24; a support bracket 26 arranged at the front end of the backlight frame 24 to maintain a specific state in which the diffusion plate 22 and the optical sheets (23A, 23B, 23C) are mounted to the backlight frame 24; and an installation bracket 27 arranged at the outside of the rear chassis 25 in a manner that the backlight module 20 can be installed at the main frame 30.

The light source 21 includes a plurality of light emitting diodes (LEDs) 21a installed at an inner surface of the backlight frame 24, a substrate 21b on which the LEDs 21a are positioned, and a lens 21c to disperse light generated from the LEDs 21a. In this exemplary embodiment, the LEDs 21a and the substrate 21b are arranged to face the diffusion plate 22 at the rear of the diffusion plate 22.

The diffusion plate 22 is formed of a transparent plate having a predetermined thickness so as to disperse light generated from the light source 21.

The plurality of optical sheets (23A, 23B, 23C) may include a diffusion sheet 23A, a prism sheet 23B, and a protective sheet 23C. The diffusion sheet 23A repeatedly diffuses light having passed through the diffusion plate 22. The prism sheet 23B includes a prism-shaped pattern to allow light diffused by the diffusion sheet 23A to be concentrated in a direction perpendicular to the display module 10 located at the front side of the prism sheet 23B. The protective sheet 23C is disposed at the front side of the prism sheet 23B to protect the prism sheet 23B, which is sensitive to dust, scratches, etc.

The backlight frame 24 includes a light-source accommodation unit 24a and a diffusion-plate accommodation unit 24b. The light-source accommodation unit 24a is arranged at the rear side of the backlight frame 24 so as to accommodate the light source 21 therein. The diffusion-plate accommodation unit 24b is arranged at the front side of the light-source accommodation unit 24a so as to accommodate the diffusion plate 22 therein.

The rear chassis 25 is formed of a metal material for heat radiation, and is arranged at the rear side of the backlight frame 24 so as to cover an external part of the light-source accommodation unit 24a.

The support bracket 26 is formed to have an L-shaped cross section, and is arranged at the front end of the backlight frame 24. The support bracket 26 supports the diffusion plate 22 and the end part of the outer wall of the optical sheets (23A, 23B, 23C) mounted to the front surface of the diffusion plate 22, such that the support bracket 25 can maintain a specific state in which the diffusion plate 22 and the optical sheets (23A, 23B, 23C) are installed into the diffusion-plate accommodation unit 24b.

The installation bracket 27 is fixed to the external part of the rear chassis 25, and is formed stepwise in a manner that the installation bracket 27 can be caught by the catching protrusion 30b of a main frame to be described later. The installation bracket 27 is fixed to the rear chassis 25 and the main frame 30 through a coupling member S such as a screw, so that the backlight module 20 is fixed to the main frame 30.

The main frame 30 is formed in a rectangular ring-shape, and the display module 10 and the backlight module 20 are supported and installed in the main frame 30.

A seating groove 30a in which the end part of the outer wall of the spacing panel 13 is seated and supported is concavely provided at the front side of an inner surface of the main frame 30. The catching protrusion 30b by which the installation bracket 27 is caught and supported is provided at the rear side of the inner surface of the main frame 30. The backlight module 20 is mounted to the rear side of the inside of the main frame 30, and the display module 10 is mounted to the front side of the inside of the main frame 30.

As described above, the outer wall of the spacing panel 13, which protrudes above the first display panel 11 and the second display panel 12, is seated and supported in the seating groove 30a of the main frame 30, and force or pressure is not applied to the first display panel 11 and the second display panel 12, such that transformation of the first display panel 11 and the second display panel 12 and image distortion caused by the transformation of the first and second display panels can be prevented from occurring.

The case 40 is formed in a rectangular shape and has an L-shaped cross section, such that the case 40 may form not only the outer wall of the front surface of the 3D image display device 1A, but may also form four lateral sides of top, bottom, left and right sides of the 3D image display device 1A. In this exemplary embodiment, the case 40 may include not only a bezel portion 40a to cover the outer wall of the second display panel 12, but also a lateral portion 40b to cover four lateral sides of top, bottom, left and right sides of the main frame 30. The case 40 is fixed to the main frame through the coupling member S such as a screw.

The first PCB 11a may be arranged parallel to the first display panel 11 at the rear of one side of the first display panel 11. The second PCB 12a may be arranged perpendicular to the second display panel 12 at one side of the second display panel 12.

The first PCB 11a is seated and supported at a back surface of the rear chassis 25. The second PCB 12a is accommodated in a substrate accommodation groove 30c concaved to accommodate the second PCB 12a therein, and the substrate accommodation groove 30c is formed at the external surface of the main frame 30.

If the first PCB 11a and the second PCB 12a are arranged as described above, the 3D image display device is formed to have a predetermined thickness or less and the bezel portion 40a is formed to have a predetermined width or less.

In this exemplary embodiment, although the first PCB 11a may be arranged parallel to the first display panel 11 and the second PCB 12a may be arranged perpendicular to the second display panel 12, the scope or spirit of the exemplary embodiments is not limited thereto. The first PCB 11a and the second PCB 12a can be arranged in various ways as shown in the following exemplary embodiments.

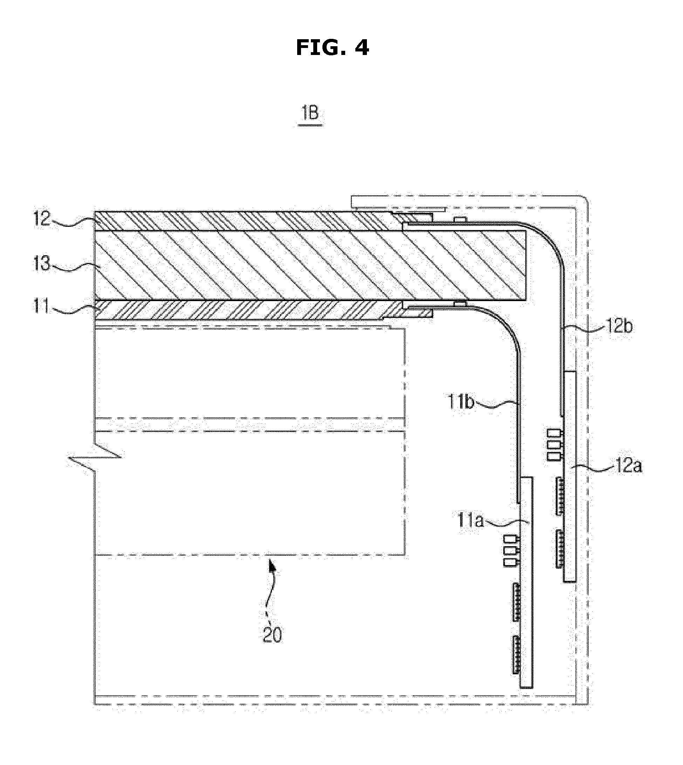

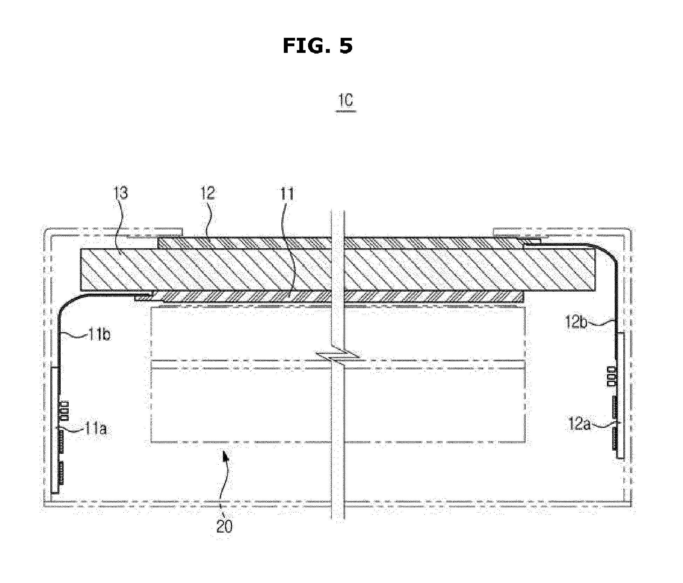

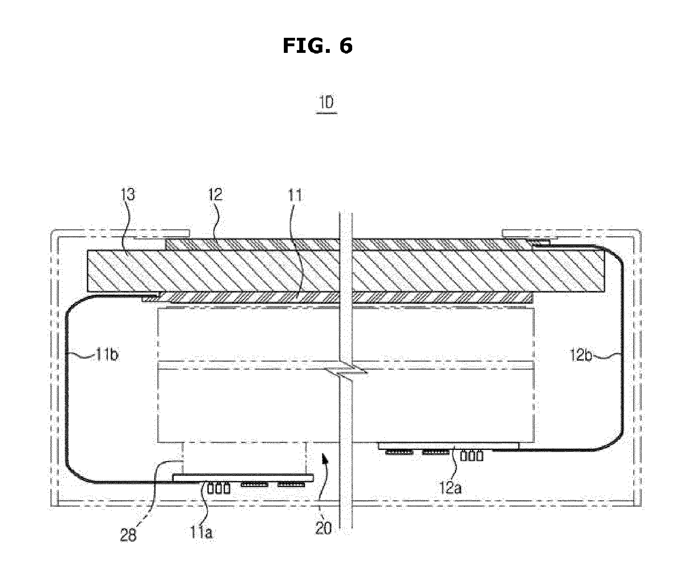

FIG. 4 is a cross-sectional view illustrating the 3D image display device 1B according to a second exemplary embodiment. FIG. 5 is a cross-sectional view illustrating the 3D image display device 1C according to a third exemplary embodiment. FIG. 6 is a cross-sectional view illustrating the 3D image display device 1D according to a fourth exemplary embodiment. The 3D image display devices (1B, 1C, 1D) may have substantially the same structure, except for the various manners in which the first PCB 11a and the second PCB 12a are arranged.

As shown in FIG. 4, the 3D image display device 1B according to the second exemplary embodiment includes not only the first PCB 11a that is perpendicular to the first display panel 11 and coupled to one side of the first display panel 11, but also the second PCB 12a that is perpendicular to the second display panel 12 and coupled to one side of the second display panel 12. In more detail, the first PCB 11a and the second PCB 12a are disposed to be spaced parallel to each other.

If the first PCB 11a and the second PCB 12a are arranged as described above, only one substrate accommodation groove 30c is formed at one side of the main frame 30, and both the first PCB 11a and the second PCB 12a can be accommodated in the substrate accommodation unit 30c.

Referring to FIG. 5, the 3D image display device 1C according to the third exemplary embodiment includes not only the first PCB 11a arranged perpendicular to the first display panel 11, but also the second PCB 12a arranged perpendicular to the second display panel 12. In more detail, the first PCB 11a is arranged at a first end of the first display panel 11, and the second PCB 12a is arranged at a second end of the second display panel 12, where the second end is located opposite to the first end.

If the first PCB 11a and the second PCB 12a are arranged as described above, the first PCB 11a and the second PCB 12a may be respectively arranged at both sides of the main frame, such that the bezel portion 40a arranged at the front side of the first PCB 11a and the second PCB 12a can be reduced in width.

Referring to FIG. 6, the 3D image display device 1D according to the fourth exemplary embodiment includes not only the first PCB 11a arranged parallel to the first display panel 11, but also the second PCB 12a arranged parallel to the second display panel 12. In more detail, the first PCB 11a may be arranged at the rear of a first end of the first display panel 11, and the second PCB 12a may be arranged at the rear of a second end of the second display panel 12, where the second end is located opposite to the first end.

In this case, the first display panel 11 and the second display panel 12 are spaced from each other in a forward and backward direction through the spacing panel 13, and the first PCB 11a extended from the first display panel 11 and the second PCB 12a extended from the second display panel 12 must be spaced from each other in a forward and backward direction. Therefore, the second PCB 12a is mounted to a back surface of the rear chassis 25, and the first PCB 11a is mounted to a back surface of the rear chassis 25 through a spacer 28.

If the first PCB 11a and the second PCB 12a are arranged as described above, there is no need to form the substrate accommodation groove in the main frame 30 because the first PCB 11a and the second PCB 12a are arranged at the rear of the rear chassis 25, resulting in implementation of a minimum width of the bezel portion 40a.

As is apparent from the above description, the exemplary embodiments provide various manners for arranging a first PCB and a second PCB in a 3D image display device having a first display panel and a second display panel that are spaced apart from each other in a forward and backward direction.

In addition, the first display panel and the second display panel are respectively attached to a first side and a second side of a spacing panel which has a predetermined thickness, such that a predetermined distance between the first display panel and the second display panel can be correctly maintained.

Although a few exemplary embodiments have been shown and described, it would be appreciated by those skilled in the art that changes may be made in these exemplary embodiments without departing from the principles of the invention, the scope of which is defined in the claims.

## Claims

1. A three-dimensional 3D image display device comprising:
a display module; and
a main frame configured to support the display module,
wherein the display module comprises:
a first display panel configured to display a two-dimensional 2D image;
a second display panel spaced apart from the first display panel and configured to display a three-dimensional 3D image;
a first printed circuit board PCB configured to control the first display panel;
a second PCB configured to control the second display panel;
a first flexible PCB which interconnects the first display panel and the first PCB; and
a second flexible PCB which interconnects the second display panel and the second PCB.

2. The three-dimensional 3D image display device according to claim 1, wherein the display module further comprises a spacing panel, and wherein the first display panel is coupled to a back surface of the spacing panel, and the second display panel is coupled to a front surface of the spacing panel.

3. The three-dimensional 3D image display device according to claim 2, wherein the spacing panel is formed of a transparent material.

4. The three-dimensional 3D image display device according to claim 2 or 3, wherein:
an outer wall of the spacing panel protrudes above the first display panel and the second display panel; and
the main frame supports a circumference of the spacing-panel which protrudes above the first display panel and the second display panel.

5. The three-dimensional 3D image display device according to claim 4, wherein the main frame is formed in a rectangular shape, and comprises a seating groove in which the outer wall of the spacing panel is seated.

6. The three-dimensional 3D image display device according to any one of the preceding claims, further comprising:
a case which is coupled to the main frame,
wherein the case comprises a bezel portion which covers an outer wall of the second display panel and a lateral portion which covers a lateral surface of the main frame.

7. The three-dimensional 3D image display device according to any one of the preceding claims, further comprising a backlight module at a rear of the display module, wherein the main frame is configured to support the display module and the backlight module.

8. The three-dimensional 3D image display device according to claim 7, wherein:
the main frame comprises a catching protrusion which protrudes from an end part of the main frame; and
the backlight module comprises an installation bracket mounted to an external part of the backlight module, wherein the backlight module is supported by the catching protrusion.

9. The three-dimensional 3D image display device according to claim 7 or 8, wherein the backlight module comprises:
a light source;
a diffusion plate which is located at a front side of the light source;
a backlight frame which supports the light source and the diffusion plate;
a support bracket which is installed on the backlight frame and which supports an outer wall of the diffusion plate; and
a rear chassis which covers a rear side of the backlight frame.

10. The three-dimensional 3D image display device according to claim 9, wherein the light source comprises a plurality of light emitting diodes LEDs and a substrate on which the LEDs are positioned.

11. The three-dimensional 3D image display device according to any one of the preceding claims, wherein the first PCB and the second PCB are spaced parallel to each other in a direction perpendicular to the plane of the first display panel and the second display panel.

12. The three-dimensional 3D image display device according to claim 11, wherein the first PCB is coupled to one end of the first display panel and the second PCB is coupled to one end of the second display panel, and the first PCB and the second PCB are spaced parallel to each other,
or wherein:
the first PCB is arranged at a first end of the first display panel, and
the second PCB is arranged at a second end of the second display panel, and the second end is located opposite to the first end.

13. The three-dimensional 3D image display device according to claim 1, wherein:
the first PCB is arranged parallel to the first display panel at a rear of the first display panel; and
the second PCB is arranged perpendicular to the second display panel.

14. The three-dimensional 3D image display device according to claim 1, wherein:
the first PCB is arranged parallel to the first display panel at a rear of a first end of the first display panel; and
the second PCB is arranged parallel to the second display panel at a rear of a second end of the second display panel, and the second end is located opposite to the first end,
wherein the first PCB is arranged at a rear of the second PCB in response to a spacing distance between the first display panel and the second display panel.

15. The three-dimensional (3D) image display device according to any one of the preceding claims, wherein the main frame comprises a substrate accommodation groove which is concaved at an external surface of the main frame and the substrate accommodation groove accommodates at least the second PCB.
